# EUROPÄISCHE PATENTANMELDUNG

(11) **EP 0 651 509 A1**
(43) Veröffentlichungstag der Anmeldung: **03.05.1995**
(21) Anmeldenummer: 94115929.5
(22) Anmeldetag: 10.10.1994
(51) Int. Cl.: H03K 17/94

(54) **Eingabefeld**

(30) Priorität: 27.10.1993 DE 4336669
(71) Anmelder: Hydrometer Gesellschaft mbH, D-91522 Ansbach (DE)
(72) Erfinder: Ziegler, Horst Prof. Dr., 33100 Paderborn (DE)
(74) Vertreter: Matschkur, Götz, Lindner Patent- und Rechtsanwälte

(57) **Zusammenfassung**

Ein optoelektronisch arbeitendes Eingabefeld hat hinter Betätigungsflächen sitzende, als Fotoelemente arbeitende Fotodioden (24), deren Ausgangssignale über Differenzierkreise (26) auf Schwellwertschalter (28) gegeben werden. An die Ausgänge der verschiedenen Schwellwertschalter (28) ist ein Festwertspeicher (54) angeschlossen, in welchem für zulässige Signalkombinationen Freischaltsignale abgelegt sind, mit denen ausgangsseitige UND-Glieder (52) des Eingabefeldes durchschaltbar sind.

## Beschreibung

Die Erfindung betrifft ein Eingabefeld gemäß dem Oberbegriff des Anspruches 1.

Eingabefelder sind als mechanische Tastenfelder, inklusive Folientastaturen, sowie in Form von kapazitiven Tastenfeldern in verschiedener Form im Einsatz. Die einzelnen Tasten haben hier auf der sie tragenden Platine einen erheblichen Platzbedarf, und zwischen der Platine und der Betätigungsfläche muß ein fest vorgegebener Abstand vorliegen. Dies wiederum ist im Hinblick für kombinierte Anzeige/Betätigungsfelder von Nachteil, da die anderen, auf derselben Platine anzubringenden Elemente wie eine LCD- oder LED-Anzeige, integrierte Schaltkreise oder einzelne Elektronikkomponenten wie Kondensatoren usw. im Einzelfalle unterschiedliche Abstände zwischen einer die gesamte Platine überdeckende Abdeckplatte und der Platine erfordern.

Es sind auch Eingabefelder bekannt, bei welchen den einzelnen Betätigungsflächen optoelektronische Betätigungssensoren zugeordnet sind, welche auf Helligkeitsänderungen ansprechen, die beim Aufsetzen des Fingers auf die Betätigungsfläche eintreten. Derartige optische Tasten arbeiten aber nur dann zufriedenstellend, wenn das Umgebungslicht im wesentlichen gleichbleibend ist. Bei Tageslicht-Anwendungen, bei denen sich die Helligkeit der Umgebung von weniger als einem Lux (Betätigungsfläche gerade erkennbar) auf über 100.000 Lux (helles Sonnenlicht) ändern kann, kann im Hinblick darauf, daß der Finger einer Person im üblicher Weise verwendeten Spektralgebiet des nahen IR (800-1.000 nm) eine Lichtabschwächung nur um einen Faktor 100 bringt, eine universell verwendbare Schaltschwelle nicht gefunden werden. Hinzu kommt, daß derartige bekannte optoelektronische Tasten einen honen Stromverbrauch haben, der den Einsatz in batteriegetriebenan Geräten verbietet. Ein getaktetes Betreiben der optischen Taste führt zum einen zu Schwierigkeiten mit sinusmoduliertem Umgebungslicht, wie es zum Beispiel von Leuchtstoffröhren abgegeben wird, zum anderen können bei solchen getakteten Anwendungen möglicherweise kurzfristige Betätigungsvorgänge undetektiert bleiben.

Durch die vorliegende Erfindung soll daher ein Eingabefeld gemäß dem Oberbegriff des Anspruches 1 so weitergebildet werden, daß einerseits Betätigungen auch bei starken Schwankungen der Stärke des Umgebungslichtes sicher erkannt werden, andererseits derartige starke Schwankungen des Umgebungslichtes nicht ihrerseits zur Abgabe von Ausgangssignalen führen.

Diese Aufgabe ist erfindungsgemäß gelöst durch ein Eingabefeld mit den im Anspruch 1 angegebenen Merkmalen.

Bei dem erfindungsgemäßen Eingabefeld werden als Betätigungssensoren solche verwendet, bei denen sich die Amplitude des Ausgangssignales mit Änderungen in der auffallenden Lichtintensität nur verhältnismäßig wenig ändert. Damit führen auch starke Änderungen in der Umgebungshelligkeit nicht zu großen Änderungen im Ausgangssignal. Damit ist es möglich, daß bei rascher Änderung in der Helligkeit des auffallenden Lichtes, wie sie typischerweise beim Aufsetzen eines Fingers auf die Betätigungsfläche erhalten wird, eine stärkere zeitliche Änderung im Ausgangssignal des zugeordneten Betätigungssensors erhalten wird, als bei demgegenüber starker, jedoch über einen größeren Zeitraum verteilter Änderung der Beleuchtungsstärke. Die entsprechende Unterscheidung zwischen raschen Änderungen auch kleiner Amplitude von langsamen Änderungen großer Amplitude besorgt erfindungsgemäß die Auswerteeinheit.

Bei dem erfindungsgemäßen Eingabefeld brauchen auf der Platine nur die Betätigungssensoren angebracht zu werden, bei denen es sich typischerweise um kleinbauende Halbleiterelemente handelt. Diese Elemente brauchen keine gesonderten Platz in Anspruch nehmenden Tastengehäuse. Sie können auch in in weitem Umfange variablem Abstand von einer die Betätigungsflächen tragenden Abdeckplatte angeordnet werden, so daß man auf einer Platine des Eingabefeldes auch noch weitere Anzeigeelemente oder elektronische Bauelemente unterbringen kann, was die Herstellung und einen kompakten und dichten Aufbau der Gesamtanordnung vereinfacht.

Vorteilhafte Weiterbildungen der Erfindung sind in Unteransprüchen angegeben.

Mit der Weiterbildung der Erfindung gemäß Anspruch 2 wird erreicht, daß man für einen großen Bereich der Umgebungshelligkeit im wesentlichen die gleichen Verhältnisse bezüglich der Unterscheidung von solchen Ausgangssignalen der Betätigungssensoren, die innerhalb kurzer Zeit erfolgen, jedoch kleine Amplitude haben, von solchen Änderungen der Ausgangssignale erhält, bei denen die Amplitudenänderung groß ist, jedoch nur in einem großen Zeitraum erfolgt.

Die Weiterbildung der Erfindung gemäß Anspruch 3 ist im Hinblick auf geringen Stromverbrauch des Eingabefeldes von Vorteil, da die Betätigungssensoren als Energiequelle das auf sie auffallende Licht verwenden.

Verwendet man Fotodioden, Fototransistoren oder (entgegen ihrer eigentlichen Bestimmung) Leuchtdioden als Fotoelemente, wie im Anspruch 4 angegeben, so sind die Kosten für die Betätigungssensoren besonders gering, da diese Bauelemente in großen Stückzahlen und preiswert hergestellt werden. Diese Elemente zeichnen sich auch durch sehr geringe Abmessungen aus und lassen sich problemlos auf gedruckten Schaltungen anbringen. Verwendet man diese Elemente im Generatormode (Spannungserzeugung aus dem auffallenden Licht), haben sie zudem auch nur geringen Energieverbrauch.

Mit der Weiterbildung der Erfindung gemäß Anspruch 6 erhält man eine nochmals größere Unempfindlichkeit des Eingabefeldes gegen langsame Änderungen in der Umgebungshelligkeit.

Bei einem Eingabefeld gemäß Anspruch 7 ist zusätzlich gewährleistet, daß auch rasche Änderungen in der Umgebungshelligkeit nicht zu fehlerhaften Ausgangssignalen führen, wobei dies am gleichzeitigen Ansprechen einer vorgegebenen Anzahl von Betätigungssensoren festgestellt wird. Auf diese Weise kann man auch Falschbedienungen erkennen, zum Beispiel das Ablegen eines Gegenstandes auf dem Eingabefeld.

Die Weiterbildung der Erfindung gemäß Anspruch 8 macht das Eingabefeld unempfindlich gegen im Umgebungslicht ständig vorhandene Intensitätsmodulationen.

Nachstehend wird die Erfindung anhand von Ausführungsbeispielen unter Bezugnahme auf die Zeichnung näher erläutert. In dieser zeigen:
- Figur 1:: eine Aufsicht auf die Stirnseite eines Betätigungsmoduls;
- Figur 2:: ein Blockschaltbild eines Tastenkanales des Betätigungsmoduls nach Figur 1;
- Figur 3:: die Kennlinie eines Betätigungssensors des Betätigungsmoduls nach Figur 1;
- Figur 4:: das Blockschaltbild eines abgewandelten Betätigungsmoduls;
- Figur 5:: das Blockschaltbild eines abgewandelten Eingabefeldes für ein Betätigungsmodul; und
- Figur 6:: ein Blockschaltbild eines nochmals abgewandelten Eingabefeldes.

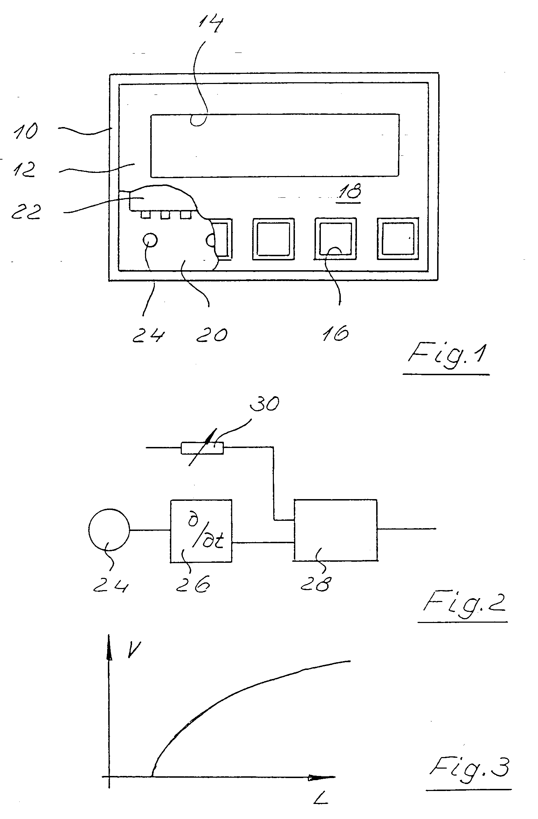

In Figur 1 ist mit 10 das Gehäuse eines Betätigungsmoduls bezeichnet, welches eine von Hause aus transparente Abdeckplatte 12 aufweist, die jedoch mit Ausnahme eines Anzeigefensters 14 und von Betätigungsfeldern 16 mit einer opaken Farbschicht 18 bedruckt ist.

Im Inneren des Gehäuses 10 ist eine Platine 20 angeordnet, welche ein hinter dem Anzeigefenster 14 liegendes LCD-Display und hinter den Betätigungsfeldern 16 liegende Fotodioden 24 trägt. In weiteren Bereichen der Platine 20 können in der Zeichnung nicht wiedergegebene integrierte Schaltkreise und Einzel-Bauelemente wie Widerstände, Kondensatoren und Relais oder dergleichen angeordnet sein.

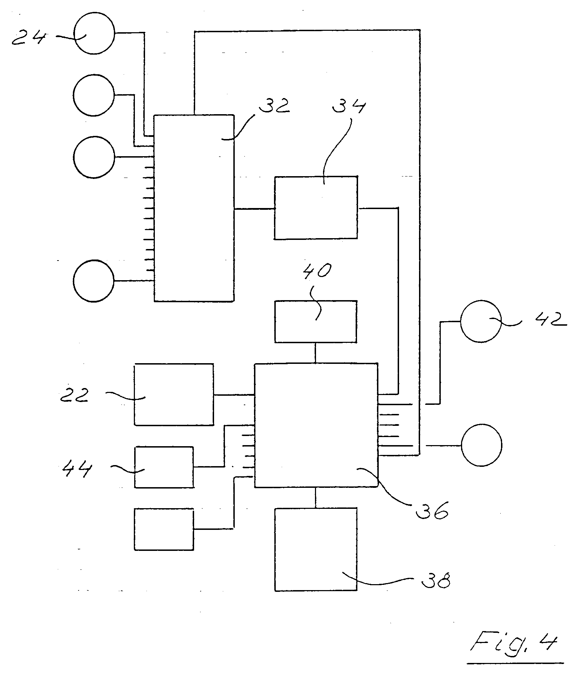

Die Fotodioden 24 werden als Fotoelemente eingesetzt und erzeugen, wie in Figur 3 gezeigt, eine Ausgangsspannung V, die in Abhängigkeit von dem auf sie auffallenden Lichtstrom L in etwa logarithmisch zunimmt.

Wie aus Figur 2 ersichtlich, ist an den Ausgang einer Fotodiode 24 jeweils ein Differenzierkreis 26 angeschlossen, und dessen Ausgang ist mit dem Signaleingang eines Schwellwertschalters 28 verbunden. Dessen Referenzsignaleingang ist mit einem Potentiometer 30 verbunden. Die gesamte Anordnung sei zu Erläuterungszwecken so getroffen, daß der Schwellwertschalter 28 immer dann ein Ausgangssignal bereitstellt, wenn die Steilheit der abfallenden Flanke des Ausgangssignales der Leuchtdiode 24 eine vorgegebene Steilheit überschreitet, also die Intensität des auf die Fotodiode 24 auffallenden Lichtes rasch abnimmt.

Aufgrund der in Figur 3 gezeigten logarithmischen Kennlinie der Fotodiode 24 führen so rasche Änderungen in der Helligkeit des auffallenden Lichtes, wie sie typischerweise beim Aufsetzen eines Fingers auf ein Betätigungsfeld 16 erhalten werden, zu größeren Signaländerungen am Signaleingang des Schwellwertschalters 28 als große Änderungen in der Helligkeit des auf die Fotodiode 24 fallenden Lichtes, welche sich über einen größeren Zeitraum verteilen. Auf diese Weise werden in dem in Figur 2 gezeigten Tastenkanal betätigungsbedingte Helligkeitsänderungen von umgebungsbedingten Helligkeitsänderungen unterschieden.

Bei den Figur 4 dargestellten Ausführungsbeispiel erfolgt dieses Unterscheiden auf digitalem Wege.

Die verschiedenen Fotodioden 24 sind mit Eingängen eines Multiplexers 32 verbunden und über diesen mit dem Eingang eines Analog/Digitalwandlers 34 verbunden, dessen Eingang im Hinblick auf die von den Leuchtdioden abgegebenen nur kleinen Fotoströme (einige nA) sehr hochohmig gewählt ist (CMOS-Technologie).

Der Ausgang des Analog/Digitalwandlers 34 ist mit einem Eingang eines Mikroprozessors 36 verbunden, der mit einem Schreib/Lesespeicher 38 und einer Uhr 40 zusammenarbeitet. Der Mikroprozessor 36 steuert den Multiplexer 32 in regelmäßigen Abständen um eine Meßstelle weiter und legt die dann jeweils am Ausgang des Analog/Digitalwandlers 34 erhaltenen Signale in zugeordneten Speicherzellen des Schreib/Lesespeichers 38 ab. In jedem Meßzyklus prüft der Mikroprozessor 36 ferner, ob sich der neu erhaltene Signalwert für die gerade auf den Analog/ Digitalwandler 34 geschaltete Fotodiode 24 vom im vorhergehenden Meßzyklus erhaltenen Wert um mehr als eine vorgegebene Schwelle unterscheidet. Ist dies der Fall, so wird dies als Betätigung der entsprechenden Taste durch Auflegen eines Fingers auf das zugeordnete Betätigungsfeld 16 ausgelegt und eine entsprechende Information an dem Tastaturtreiber übergeordnete Programme des Mikroprozessors 36 weitergegeben.

Gemäß einer so erhaltenen Eingabe kann dann der Mikroprozessor 36 Anzeigen auf dem LCD-Display 22 vornehmen, Ausgangssignale weiterer Fühler 42 verarbeiten oder verschiedene angeschlossene Lasten 44 steuern.

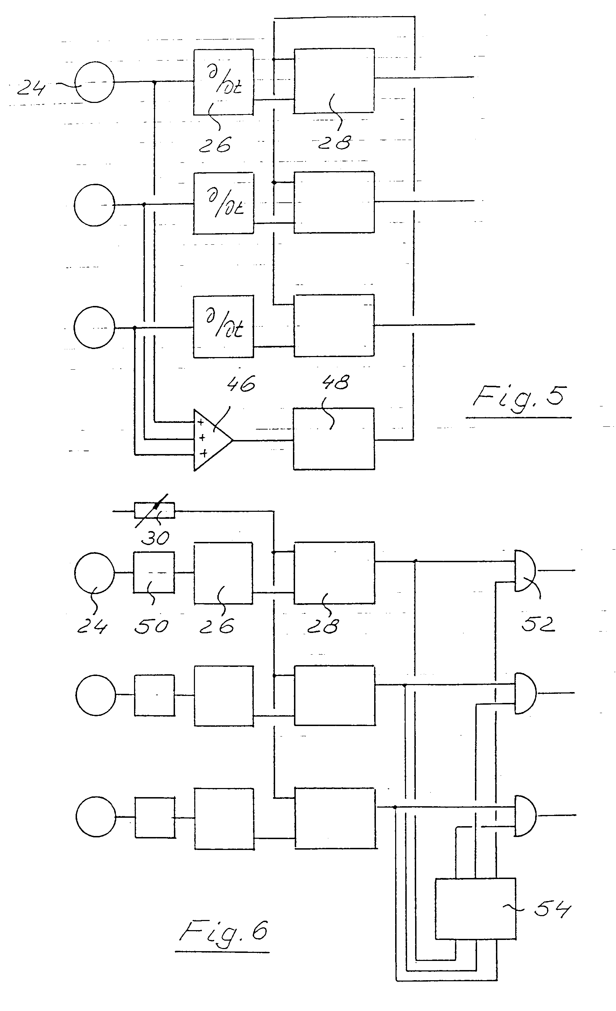

Bei dem Ausführungsbeispiel nach Figur 5 sind unter Bezugnahme auf Figur 2 schon erläuterte Bauelemente wieder mit denselben Bezugszeichen versehen.

Die Ausgänge der verschiedenen Fotodioden 24-i sind nun zusätzlich mit zugeordneten Eingängen eines Summierverstärkers 46 verbunden. Dessen Ausgangssignal wird auf den Eingang eines Kennlinienkreises 48 gegeben, dessen Ausgang mit den Referenzsignaleingängen der Schwellwertschalter 28 verbunden ist. Im Kennlinienkreis 48 sind die für eine vorgegebene Umgebungshelligkeit jeweils geltenden Schaltschwellen abgelegt, die zum Beispiel zuvor empirisch ermittelt wurden.

Beim Ausführungsbeispiel nach Figur 6 ist an den Ausgang der Fotodioden 24-i jeweils ein RC-Filter 50 angeschlossen, welcher im Umgebungslicht einhaltene Wechselanteile vorgegebener Frequenz (50 Hz oder 100 Hz) glättet, so daß diese hochfrequenten Anteile nicht mehr über die Differenzierkreise 26 auf die Schwellwertschalter 28 gelangen.

Die Ausgangssignale der Schwellwertschalter 28 werden auf die einen Eingänge ausgangseitiger UND-Glieder 52 gegeben, deren zweite Eingänge mit Ausgängen eines Festwertspeichers 54 verbunden sind. Die Adressklemmen des Festwertspeichers 54 sind jeweils mit dem Ausgang eines zugeordneten der Schwellwertschalter 28 verbunden.

Im Festwertspeicher 54 ist für jedes Eingangssignal, welches einer entsprechenden Kombination "betätigter" Fotodioden 24 entspricht, abgelegt, ob eine solche "Betätigung" eine zulässige und damit weiterzugebende Betätigung oder die Folge einer Änderung in den Umgebungsbedingungen ist.

So ist zum Beispiel im Festwertspeicher 54 der Adresse "111" (alle drei Fotodioden 24 zeigen einen raschen Helligkeitsabfall) der Speicherzelleninhalt "000" zugeordnet, so daß durch die UND-Glieder 52 das Ausgeben eines Ausgangssignales verhindert wird.

Für die oben genannten Zwecke ist es im Prinzip ausreichend, nur ein Bit lange Worte zu verwenden und die in der Zeichnung unten liegenden Eingänge der UND-Glieder alle mit dem Ausgang des Festwertspeichers 54 zu verbinden. Verwendet man gemäß der Zeichnung jedoch mehrere Bits umfassende Worte im Festwertspeicher 54, so kann man das Ausgangssignal des Maskenfeldes je nach dem aufgetretenen keiner Betätigung zuzuordnenden Zustand in gezielter Weise maskieren.

## Patentansprüche

1. Eingabefeld mit mindestens einem Betätigungsfeld (16), dem ein optoelektronischer Betätigungssensor (24) zugeordnet ist, und mit einer mit den Betätigungssensoren (24) verbundenen Auswerteeinheit, dadurch gekennzeichnet, daß die Betätigungssensoren (24) ein mit zunehmender Beleuchtungsstärke nur schwach anwachsendes Ausgangssignal bereitstellen und daß die Auswerteeinheit Unterscheidungsmittel (26, 28; 34-38) zum Unterscheiden von raschen, niederpegeligen Änderungen in den Ausgangssignalen der Betätigungssensoren (24) von langsamen hochpegeligen Änderungen in diesen Ausgangssignalen aufweisen.

2. Eingabefeld nach Anspruch 1, dadurch gekennzeichnet, daß die Betätigungssensoren (24) ein Ausgangssignal bereitstellen, welches im wesentlichen logarithmisch mit der Intensität des auf sie auffallenden Lichtes anwächst.

3. Eingabefeld nach Anspruch 1 oder 2, dadurch gekennzeichnet, daß die Betätigungssensoren (24) als Fotoelemente arbeitende Halbleiterelemente aufweisen.

4. Eingabefeld nach Anspruch 3, dadurch gekennzeichnet, daß die Halbleiterelemente Fotodioden (24) oder Fototransistoren oder Leuchtdioden sind und im Generatormode betrieben werden.

5. Eingabefeld nach einem der Ansprüche 1-4, dadurch gekennzeichnet, daß die Unterscheidungsmittel für jeden Betätigungssensor (24) einen mit dessen Ausgangssignal beaufschlagten Differenzierkreis (26) und einen dessen Ausgangssignal erhaltenden Schwellwertschalter (28) aufweisen.

6. Eingabefeld nach Anspruch 5, dadurch gekennzeichnet, daß die Schwellwertschalter (28) jeweils mit einem Referenzsignal beaufschlagt sind, welches vom Ausgangssignal eines Summierverstärkers (46) abhängt, der eingangsseitig mit mindestens zwei Betätigungssensoren (24) verbunden ist.

7. Eingabefeld nach einem der Ansprüche 1-6, dadurch gekennzeichnet, daß die Auswerteeinheit eine Logikschaltung (54) enthält, welche eingangsseitig mit Signalen beaufschlagt ist, die von den Ausgangssignalen mindestens zweier Betätigungssensoren (24) abgeleitet sind, wobei die Logikschaltung vorgegebene zulässige Betätigungskombinationen erkennt und an mindestens einem Ausgang bei Vorliegen zulässiger Betätigungskombinationen ein Freischaltsignal bereitstellt, und daß den Ausgängen der Auswerteeinheit UND-Glieder (52) vorgeschaltet sind, deren eine Eingänge mit einem vom Ausgangssignal und deren zweite Eingänge mit dem Freischaltsignal beaufschlagt sind.

8. Eingabefeld nach einem der Ansprüche 1-7, dadurch gekennzeichnet, daß das Ausgangssignal der Betätigungssensoren (24) jeweils über einen Filterkreis (50) läuft, der auf moduliertes Umgebungslicht zurückzuführende Wechselspannungsanteile des Ausgangssignales glättet.
